(19) Europäisches Patentamt
European Patent Office
Office européen des brevets

(11) EP 2 470 923 B1

(12) FASCICULE DE BREVET EUROPEEN

(45) Date de publication et mention de la délivrance du brevet:
**15.02.2017 Bulletin 2017/07**

(21) Numéro de dépôt: **10763760.5**

(22) Date de dépôt: **27.08.2010**

(51) Int Cl.:
*G01R 33/383* (2006.01)     *G01R 33/30* (2006.01)
*H01F 7/02* (2006.01)

(86) Numéro de dépôt international:
**PCT/FR2010/051784**

(87) Numéro de publication internationale:
**WO 2011/023913 (03.03.2011 Gazette 2011/09)**

(54) **STRUCTURE AIMANTÉE INDUISANT EN SON CENTRE UN CHAMP HOMOGÈNE D'ORIENTATION PRÉDÉTERMINÉE**

MAGNETISIERTE STRUKTUR ZUR INDUKTION EINES HOMOGENEN FELDES IN DER MITTE MIT VORDEFINIERTER AUSRICHTUNG

MAGNETISED STRUCTURE INDUCING A HOMOGENEOUS FIELD, IN THE CENTRE THEREOF, WITH A PRE-DETERMINED ORIENTATION

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **28.08.2009 FR 0955892**

(43) Date de publication de la demande:
**04.07.2012 Bulletin 2012/27**

(73) Titulaire: **Commissariat à l'Énergie Atomique et aux Énergies Alternatives 75015 Paris (FR)**

(72) Inventeurs:
• **SAKELLARIOU, Dimitrios**
  **F-92100 Boulogne Billancourt (FR)**
• **HUGON, Cedric**
  **F-92140 Clamart (FR)**
• **AUBERT, Guy**
  **F-86000 Poitiers (FR)**

(74) Mandataire: **Desormiere, Pierre-Louis et al Cabinet Beau de Loménie 158, rue de l'Université 75340 Paris Cedex 07 (FR)**

(56) Documents cités:
WO-A1-88/10500       WO-A1-2006/024775
WO-A1-2007/120057    WO-A2-2006/047580
US-A- 4 999 600      US-A- 5 014 032
US-A- 5 523 732

**Description**

Domaine de l'invention

La présente invention a pour objet une structure aimantée appliquée à un appareil de Résonance Magnétique Nucléaire induisant dans une zone d'intérêt centrale un champ magnétique homogène d'orientation prédéterminée par rapport à un axe longitudinal de la structure, comprenant au moins des première et deuxième couronnes aimantées disposées de façon symétrique par rapport à un plan qui est perpendiculaire audit axe longitudinal et contient ladite zone d'intérêt centrale, et au moins une structure aimantée annulaire médiane interposée au moins partiellement entre les première et deuxième couronnes aimantées et également disposée de façon symétrique par rapport audit plan, la première couronne aimantée étant aimantée radialement par rapport à l'axe longitudinal avec une aimantation divergente, la deuxième couronne aimantée étant aimantée radialement par rapport à l'axe longitudinal avec une aimantation convergente, et la structure aimantée annulaire médiane étant aimantée avec une orientation différente de celle de l'aimantation des première et deuxième couronnes aimantées.

Art antérieur

Dans le domaine de la Résonance Magnétique Nucléaire (RMN), l'échantillon (objet ou patient) est placé à l'intérieur d'un champ magnétique qui doit être très intense et très homogène. Il convient donc de pouvoir fabriquer des structures aimantées capables de produire de tels champs magnétiques.

Par ailleurs il est souvent utile de pouvoir produire un champ magnétique selon une direction prédéterminée. Ainsi, par exemple, selon la technique de la rotation d'échantillon à l'angle magique (en anglais « Magic Angle Sample Spinning » ou MAS) on fait tourner rapidement un échantillon à un angle dit angle magique (de 54° 44') par rapport à la direction du champ magnétique statique, afin d'améliorer la résolution.

Les aimants utilisés actuellement en RMN pour créer des champs intenses et homogènes sont, pour la plus grande majorité, basés sur la circulation de courant dans des bobines. Que les bobines soient résistives ou supraconductrices, il y a toujours nécessité d'approvisionner l'aimant en courant et également en fluides cryogéniques dans le cas des bobines supraconductrices. Les appareils sont de ce fait encombrants et difficilement déplaçables. Des bobines résistives nécessitent d'importantes amenées de courant tandis que des bobines supraconductrices impliquent l'utilisation d'un cryostat rempli de liquides cryogéniques, qui est difficile à déplacer.

Une structure basée sur des aimants permanents permet de s'affranchir de ces contraintes puisque le matériau est aimanté une fois pour toutes et, s'il est manipulé de manière appropriée, conserve son aimantation sans maintenance extérieure. Par ailleurs, les matériaux dits permanents sont limités en rémanence (l'aimantation subsistant dans le matériau une fois aimanté) et la génération de champs importants dans de grandes zones utiles nécessite de grandes quantités de matière. La densité de ces matériaux étant d'environ 7.5 g cm$^{-3}$, on aboutit rapidement à des systèmes très lourds. Il est donc important de minimiser la quantité de matériau pour un champ donné.

La difficulté des systèmes magnétiques en matériaux permanents pour la RMN réside dans le besoin de coupler champs intenses avec forte homogénéité. Les procédés de fabrication des matériaux comme le NdFeB ne permettent pas de garantir une parfaite homogénéité d'aimantation, ni une parfaite répétitivité. Aussi, bien qu'il soit possible de calculer des structures fournissant l'homogénéité désirée, il est nécessaire de ménager des possibilités de réglages *a posteriori* qui permettent de corriger les imperfections du matériau.

La forme d'ensemble pour ces structures aimantées est généralement le cylindre, où la structure adopte au moins une symétrie axiale. Ceci permet de s'affranchir de nombreux facteurs d'inhomogénéité. La zone d'intérêt se trouve alors au centre du cylindre et l'accès à cette zone peut se faire selon l'axe en dégageant un trou dans le cylindre, ou alors par le côté en séparant le cylindre en deux.

Très peu de structures à base d'aimant permanent ont été proposées dans le passé pour générer un champ homogène longitudinal au centre. Ceci est dû au fait que les applications RMN qui nécessitent une grande homogénéité demandent aussi aux appareils d'être soit très grands (cas de l'IRM où un corps humain doit rentrer dans l'appareil), ce qui implique une énorme quantité de matériau (plusieurs tonnes), soit très intenses (c'est le cas de la spectroscopie RMN qui utilise des champs supérieurs à 10 T, jusqu'à 20 T pour le moment), ce qui n'est tout simplement pas réalisable à l'heure actuelle avec des matériaux permanents.

Ainsi, le plus ancien brevet concernant une structure cylindrique d'aimants permanents générant un champ longitudinal homogène capable *a priori* d'effectuer de la RMN est celui de Guy Aubert datant de 1991 (brevet US-A-5 014 032). Celui-ci propose d'utiliser des anneaux en matériau permanent, aimantés radialement. Les anneaux sont aimantés vers l'axe de symétrie d'un côté de la zone utile et vers l'extérieur de l'autre côté de la zone utile. La structure est symétrique par rapport au plan orthogonal à l'axe de symétrie et contenant le centre de la zone utile.

Il y a aujourd'hui un regain d'intérêt pour les structures à base de matériaux permanents car ils se trouvent très adaptés pour les applications de RMN à bas champ, portables ou transportables. De plus, les nouveaux matériaux magnétiques offrent des rémanences et coercivités bien plus élevées, permettant des champs induits suffisants (des centaines de mT) pour trouver des applications en RMN. Enfin, ces matériaux se prêtent facilement à la rotation, ce qui permettrait d'obtenir une amélioration de la résolution, à l'instar de la méthode proposée par Bloch (brevet US-A-2 960 649), cette fois en faisant tourner le champ et non l'échantillon.

Heninger *et al* ont proposé en 2006 une structure pour générer un champ longitudinal dans le contexte d'un piège à ions (demande de brevet WO 2006/024775). Cet aimant permet une homogénéité de 1 pour mille dans un volume de 10 cm$^3$ avec un champ de 1T. Cette structure ne permet donc pas une homogénéité telle que celle requise par la RMN mais produit un champ comparable en magnitude à celui de certains imageurs médicaux (1.5 T). Par ailleurs la structure proposée n'est pas simple à fabriquer.

Par ailleurs, Halbach ( K. Halbach, "Design of permanent multipole magnets with oriented rare earth cobalt material", Nuclear Instruments and Methods, v. 169, p. 1-10, 1980) a proposé des structures cylindriques permettant de créer n'importe quel multipôle avec une homogénéité parfaite, mais seulement pour un aimant théorique infiniment long. Le multipôle de Halbach le plus célèbre étant le dipôle, qui génère un champ transverse à l'axe du cylindre, arbitrairement intense par l'augmentation du rapport du rayon extérieur sur le rayon intérieur (ceci est limité par la coercivité du matériau utilisé). La structure de Halbach est exacte en deux dimensions (impliquant que la structure est infinie dans la troisième dimension) et nécessite une variation continue de l'orientation de l'aimantation dans le matériau. Ces deux conditions sont irréalisables en pratique. On peut par contre discrétiser l'orientation de l'aimantation dans la structure sous forme de secteurs. Dans le cas d'une structure 2D, l'utilisation d'un nombre suffisant de secteurs permet d'obtenir l'homogénéité à un ordre arbitrairement choisi. L'aspect tridimensionel de la structure nécessite ensuite de tenir compte des effets de bords et implique des modifications de la géométrie afin d'obtenir l'homogénéité voulue. Ceci a donné lieu à diverses mises en application.

Ces mises en application incluent les travaux de Callaghan *et al.* qui ont proposé une méthode de fabrication de structures de Halbach à partir d'aimants en forme de cubes (demande de brevet WO2007/120057) La structure résultante permet d'éliminer les termes d'ordre 2, ce qui ne permet pas une homogénéité suffisante pour être utile en RMN.

Miyata (brevet US 5 148 138) a aussi proposé une méthode de fabrication pour les structures de Halbach homogènes pour la RMN. Le brevet US 5 148 138 porte essentiellement sur l'utilisation de ferrite et de terres rares pour optimiser le poids et le coût de l'aimant.

Holsinger (demande de brevet WO 88/10500) a aussi décrit une méthode alternative de fabrication utilisant des barreaux creux pour contenir la matière aimantée. Les barreaux sont disposés de manière axisymétrique. Ces barreaux sont remplis avec des morceaux d'aimants permanents aimantés dans la bonne direction. Les barreaux sont segmentés pour ajuster l'homogénéité.

Hormis les structures de Halbach, Guy Aubert a proposé un autre type de structure créant un champ homogène transverse (brevet US 4 999 600). Cette structure permet l'accès au centre le long de l'axe de symétrie. Il a par la suite proposé dans le brevet US 5 332 971 un autre type de structure offrant un fort champ homogène en son centre. Cette dernière permet un accès transverse à la zone utile. Cette structure fait usage de deux ensembles complémentaires d'anneaux situés de part et d'autre de la zone utile.

Enfin, Leupold (brevet US 5 523 732) s'est inspiré de la structure de Halbach pour proposer un système permettant l'ajustement de la direction (dans le plan transverse) et de l'intensité du champ créé au centre.

Il y a aussi eu un regain d'intérêt pour des structures homogènes à base d'aimants permanents dans le contexte de la RMN en champ tournant (R.D. Schlueter and T.F. Budinger, "Magic angle rotating field NMR/MRI magnet for in vivo monitoring of tissue", IEEE Transactions on Applied Superconductivity, v. 18(2), p. 864-867, June 2008). Ceci fait suite à la découverte de la possibilité de tourner à faible vitesse pour augmenter la résolution (des dizaines de Hz contre des dizaines de kHz en rotation de l'échantillon classique) (R.A. Wind, J.Z. Hu and D.N. Rommereim, "High résolution 1H NMR spectroscopy in organs and tissues using slow magic angle spinning", Magnetic Resonance in Medicine, v. 46, p. 213-218, 2001). Cette avancée s'inscrit dans l'intérêt qu'il y a à obtenir des spectres haute résolution dans des échantillons que l'on ne peut pas faire tourner aux vitesses habituelles en MAS. Notamment, dans le cas d'un être humain, il n'est pas concevable de le faire tourner dans l'appareil. Aussi, la rotation du champ par rapport au sujet d'étude peut-elle se révéler particulièrement intéressante en donnant accès à la haute résolution dans les milieux anisotropes sans faire tourner le sujet. L'exploration de la RMN en champ tournant ne nécessite pas d'avoir des champs extrêmement intenses. Par contre, il faut relever le défi technologique de la rotation entre 1Hz et 10Hz de l'appareil générant le champ. En cela, les matériaux permanents sont les plus appropriés puisqu'ils ne nécessitent ni amenées de courant, ni liquides cryogéniques.

Jusqu'à présent, aucune structure d'aimants permanents n'a été proposée pour permettre la génération d'un champ arbitrairement homogène à un angle arbitraire avec l'axe de la structure. En effet, les solutions mises en application ont essentiellement consisté en l'imbrication d'un aimant permanent de type Halbach générant un champ transverse dans un électroaimant générant un champ longitudinal. L'aimant de Halbach est tourné à l'intérieur de l'électroaimant, permettant la rotation du champ. Il faut bien sûr prévoir au préalable le rapport $B_{electroaimant}$ / $B_{Halbach}$ pour obtenir l'angle désiré. Il n'y a à l'heure actuelle aucune proposition pour générer un champ homogène à un angle arbitraire uniquement à partir de pièces aimantées, d'autant plus que la manipulation de pièces aimantées pour leur assemblage s'avère délicat compte tenu de toutes les forces liées au magnétisme des pièces qui peuvent être extrêmement intenses dans le cas d'assemblage de grosses pièces.

On connaît par le document WO 2006/047580 A2) un système comprenant un aimant permanent interne associé à un moteur d'entraînement en rotation et pouvant être inséré dans la cavité centrale d'un électro-aimant, lequel électro-aimant peut être remplacé à titre de variante par un aimant permanent ayant sensiblement une forme solénoïdale. Dans ce système, un support d'échantillon est inséré dans la cavité centrale de l'aimant permanent tournant, lui-même entouré d'un électro-aimant ou aimant permanent. Lorsque l'aimant tournant est inséré dans la cavité, la superposition d'un champ magnétique transverse tournant et d'un champ magnétique axial stationnaire crée un champ magnétique tournant résultant dans la cavité.

Définition et objet de l'invention

La présente invention vise à remédier aux inconvénients mentionnés plus haut et à offrir une solution pour remédier notamment à la difficulté d'assemblage des pièces aimantées afin de former des aimants permanents puissants capables de créer un champ homogène et intense au centre de la structure aimantée, le champ induit étant orienté selon l'axe longitudinal de la structure.

L'invention peut entre autres trouver des applications dans les domaines de la RMN "légère" ou de la RMN-IRM à champ tournant.

D'une manière générale, la présente invention vise à permettre de réaliser une structure aimantée induisant en son centre un champ arbitrairement homogène ayant une direction qui peut varier de 0 à 90 degrés par rapport à l'axe longitudinal de la structure.

Ces buts sont atteints, conformément à l'invention, grâce à une structure aimantée telle que définie par la revendication indépendante 1 ou 8, appliquée à un appareil de Résonance Magnétique Nucléaire induisant dans une zone d'intérêt centrale un champ magnétique homogène d'orientation prédéterminée par rapport à un axe longitudinal de la structure, comprenant au moins des première et deuxième couronnes aimantées disposées de façon symétrique par rapport à un plan qui est perpendiculaire audit axe longitudinal et contient ladite zone d'intérêt centrale, et au moins une structure aimantée annulaire médiane interposée au moins partiellement entre les première et deuxième couronnes aimantées et également disposée de façon symétrique par rapport audit plan, la première couronne aimantée étant aimantée radialement par rapport à l'axe longitudinal avec une aimantation divergente, la deuxième couronne aimantée étant aimantée radialement par rapport à l'axe longitudinal avec une aimantation convergente, et la structure aimantée annulaire médiane étant aimantée avec une orientation différente de celle de l'aimantation des première et deuxième couronnes aimantées, caractérisée en ce que la structure aimantée annulaire médiane comprend au moins une couronne aimantée présentant une distribution d'aimantation dont l'orientation varie comme dans les dipôles de Halbach et en ce que les première et deuxième couronnes aimantées ainsi que la structure aimantée annulaire médiane sont divisées chacune en éléments constitutifs individuels en forme de secteurs identiques régulièrement répartis.

Selon la revendication indépendante 1, les éléments constitutifs individuels des couronnes pures des première et deuxième couronnes aimantées ainsi que de la structure aimantée annulaire médiane excepté ladite au moins une couronne aimantée présentant une distribution d'aimantation dont l'orientation varie comme dans les dipôles de Halbach présentent une même distribution d'aimantation.

Dans ce cas, les première et deuxième couronnes aimantées ainsi que la structure aimantée annulaire médiane sont jointives selon l'axe longitudinal.

Des secteurs jointifs permettent d'avoir le meilleur remplissage possible en matériau magnétique.

Selon un mode de réalisation préférentiel, mais non limitatif, les éléments constitutifs individuels en forme de secteurs identiques régulièrement répartis constituant une couronne pour chacune des première et deuxième couronnes aimantées ainsi que pour la structure aimantée annulaire médiane sont au moins au nombre de douze par couronne.

Selon une autre caractéristique avantageuse de l'invention, la structure annulaire médiane comprise entre les première et deuxième couronnes aimantées comprend en outre au moins deux couronnes aimantées symétriques par rapport audit plan perpendiculaire à l'axe longitudinal et présentant une aimantation à orientation axiale parallèle audit axe longitudinal dans le sens positif dudit axe longitudinal.

De façon similaire et à titre de complément ou d'alternative, la structure annulaire médiane comprise entre les première et deuxième couronnes aimantées comprend en outre au moins deux couronnes aimantées symétriques par rapport audit plan perpendiculaire à l'axe longitudinal et présentant une aimantation à orientation axiale antiparallèle audit axe longitudinal.

Selon une première mise en oeuvre possible de l'invention, tous les éléments constitutifs individuels constituant une couronne présentent une section constituée par un secteur de couronne cylindrique.

Selon une autre mise en oeuvre possible de l'invention, tous les éléments constitutifs individuels constituant une couronne présentent une section de forme trapézoïdale.

Selon encore une autre mise en oeuvre possible de l'invention, tous les éléments constitutifs individuels constituant une couronne présentent une section en forme de disque.

Selon la revendication indépendante 8, les première et deuxième couronnes aimantées ainsi que la structure aimantée annulaire médiane constituent des couronnes hybrides qui sont chacune divisées en éléments constitutifs individuels en forme de secteurs identiques régulièrement répartis, les éléments constitutifs individuels de la couronne aimantée présentant une distribution d'aimantation dont l'orientation varie comme dans les dipôles de Halbach étant au moins en partie imbriquée avec les éléments constitutifs individuels des première et deuxième couronnes aimantées.

Dans ce cas, selon une mise en oeuvre particulière possible, les éléments constitutifs individuels formant des couronnes aimantées hybrides symétriques audit plan perpendiculaire à l'axe longitudinal et présentant une aimantation à orientation axiale parallèle ou anti-parallèle audit axe longitudinal sont imbriqués avec les éléments constitutifs individuels de la couronne aimantée présentant une distribution d'aimantation dont l'orientation varie comme dans les dipôles de Halbach.

Selon une autre caractéristique particulière possible, les première et deuxième couronnes aimantées constituant des couronnes qui sont chacune divisées en éléments constitutifs individuels en forme de secteurs identiques non régulièrement répartis sont divisées en tranches le long de l'axe longitudinal, l'une au moins des tranches située le plus près dudit plan de symétrie perpendiculaire audit axe longitudinal présentant une épaisseur plus faible que les autres tranches.

De préférence, les éléments constitutifs individuels des première et deuxième couronnes aimantées sont imbriqués dans le sens azimutal de façon alternée avec les éléments constitutifs individuels de la couronne aimantée présentant une distribution d'aimantation dont l'orientation varie comme dans les dipôles de Halbach.

Brève description des dessins

D'autres caractéristiques et avantages de l'invention ressortiront de la description suivante de modes particuliers de réalisation donnés à titre d'exemples, en référence aux dessins annexés, sur lesquels :

- la figure 1 est une vue schématique d'ensemble en perspective d'une structure aimantée axisymétrique selon un premier mode de réalisation de l'invention mettant en oeuvre un empilement de couronnes « pures » aimantées,
- la figure 2 est une vue schématique d'ensemble en perspective d'une structure aimantée axisymétrique selon un deuxième mode de réalisation de l'invention mettant en oeuvre un empilement de couronnes « hybrides » aimantées,
- la figure 3 montre l'orientation de l'aimantation dans une couronne pure à aimantation radiale divergente utilisable dans une structure aimantée selon l'invention,
- la figure 4 montre l'orientation de l'aimantation dans une couronne pure à aimantation radiale convergente utilisable dans une structure aimantée selon l'invention,
- la figure 5 montre l'orientation de l'aimantation dans une couronne pure à aimantation longitudinale parallèle à l'axe longitudinal, utilisable dans une structure aimantée selon l'invention,
- la figure 6 montre l'orientation de l'aimantation dans une couronne pure à aimantation longitudinale antiparallèle par rapport à l'axe longitudinal, utilisable dans une structure aimantée selon l'invention,
- la figure 7 montre l'orientation de l'aimantation dans une couronne pure à aimantation dont l'orientation varie comme dans les dipôles de Halbach, utilisable dans une structure aimantée selon l'invention,
- les figures 8A à 12A sont des vues en perspective analogues à celles des figures 3 à 7 mais concernant des couronnes hybrides aimantées à secteurs constituant des secteurs angulaires de cylindre,
- les figures 8B à 12B sont des vues en perspective analogues à celles des figures 8A à 12A mais concernant des couronnes hybrides aimantées à secteurs de section trapézoïdale,
- les figures 8C à 12C sont des vues en perspective analogues à celles des figures 8B à 12B mais concernant des couronnes hybrides aimantées à secteurs de forme cylindrique,
- les figures 13, 14 et 15 sont des vues schématiques en perspective de trois exemples de structures aimantées axisymétriques ou quasi-axisymétriques selon l'invention qui comprennent chacune des empilements de couronnes pures aimantées,
- les figures 16 et 16A sont des vues en perspective et de dessus d'un exemple de couronne hybride comprenant des éléments constitutifs imbriqués d'une structure aimantée de type Halbach et d'une structure aimantée radiale divergente, utilisables dans une structure aimantée selon l'invention,
- les figures 17 et 17A sont des vues en perspective et de dessus d'un exemple de couronne hybride comprenant des éléments constitutifs d'une structure aimantée de type Halbach et d'une structure aimantée radiale convergente, utilisables dans une structure aimantée selon l'invention,
- la figure 18 est une vue en perspective d'un exemple de réalisation d'une couronne pure aimantée comprenant un ensemble de secteurs contigus de section trapézoïdale et utilisable dans une structure aimantée selon l'invention,
- la figure 19 est une vue en perspective d'un exemple de réalisation d'une couronne pure aimantée comprenant un ensemble de secteurs contigus de forme cylindrique et utilisable dans une structure aimantée selon l'invention,

- la figure 20 est une vue en perspective d'un exemple de réalisation d'une structure aimantée selon l'invention comprenant un empilement de couronnes pures aimantées formées chacune par des secteurs cylindriques jointifs,
- la figure 21 est une vue en perspective d'un exemple de réalisation d'une structure aimantée selon l'invention comprenant un empilement de couronnes hybrides aimantées formées chacune par des secteurs cylindriques,
- la figure 22 est une vue en perspective d'un exemple de réalisation d'une structure aimantée selon l'invention comprenant un empilement de couronnes hybrides aimantées formées chacune par des secteurs à section trapézoïdale,
- la figure 23 est une vue en perspective d'un autre exemple de réalisation d'une structure aimantée selon l'invention comprenant un empilement de couronnes hybrides aimantées formées chacune par des secteurs à section trapézoïdale, avec une division en tranches le long de l'axe longitudinal, et
- la figure 24 est une vue en perspective d'un autre exemple de réalisation d'une structure aimantée selon l'invention comprenant un empilement de couronnes hybrides aimantées formées chacune par des secteurs à section trapézoïdale, avec l'interposition de couronnes médianes supplémentaires à aimantation longitudinale parallèle et anti-parallèle.

Description détaillée des modes de réalisation préférentiels

D'une façon générale, la présente invention concerne un mode d'assemblage de pièces aimantées afin de créer un champ magnétique homogène et intense au centre de la structure. Le champ induit au centre peut présenter une orientation arbitraire par rapport à l'axe de la structure. L'orientation et l'homogénéité du champ sont contrôlées par le nombre, la disposition et les dimensions des éléments constitutifs en respectant certaines règles générales qui seront rappelées ci-dessous. Une telle structure est particulièrement intéressante pour la RMN et l'IRM et permet en particulier de créer un champ pointant essentiellement à l'angle dit "magique" (arctan $\theta_m = \sqrt{2}$ ) par rapport à l'axe de la structure aimantée.

La présente invention permet de fabriquer une famille d'aimants permanents essentiellement cylindriques, qui produisent un champ magnétique arbitrairement homogène ayant une direction qui peut varier de 0 à 90 degrés par rapport à l'axe du cylindre.

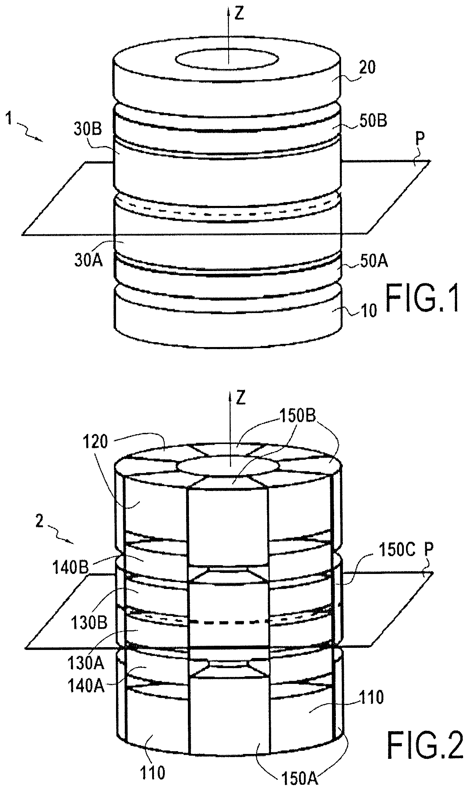

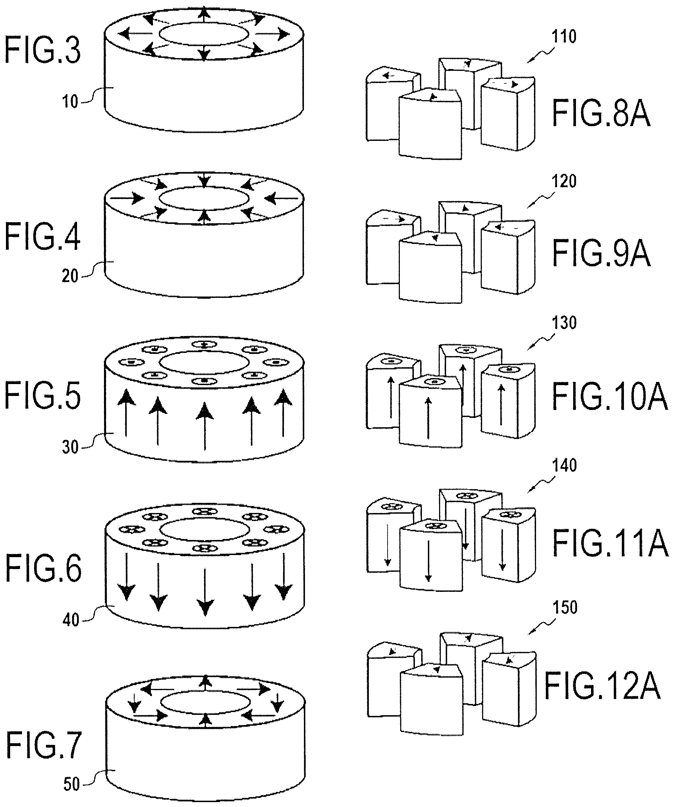

La structure générale comprend un empilement de couronnes le long de l'axe longitudinal z de la structure, comme montré sur les Figures 1 et 2. Sur la figure 1, les couronnes 10, 20, 30A, 30B, 50A, 50B constituant la structure aimantée axisymétrique 1 présentent des distributions d'aimantations continues comme celles montrées sur les figures 3 à 7. On appellera ces couronnes "pures". Ces couronnes correspondent à des distributions d'aimantation théoriques idéales dans des anneaux circulaires à section axiale rectangulaire, l'aimantation pouvant être radiale divergente (couronne 10 de la figure 3), radiale convergente (couronne 20 de la figure 4), longitudinale parallèle à l'axe z (couronne 30 de la figure 5), longitudinale anti-parallèle à l'axe z (couronne 40 de la figure 6) ou de variation continue de type dipolaire de Halbach (couronne 50 de la figure 7).

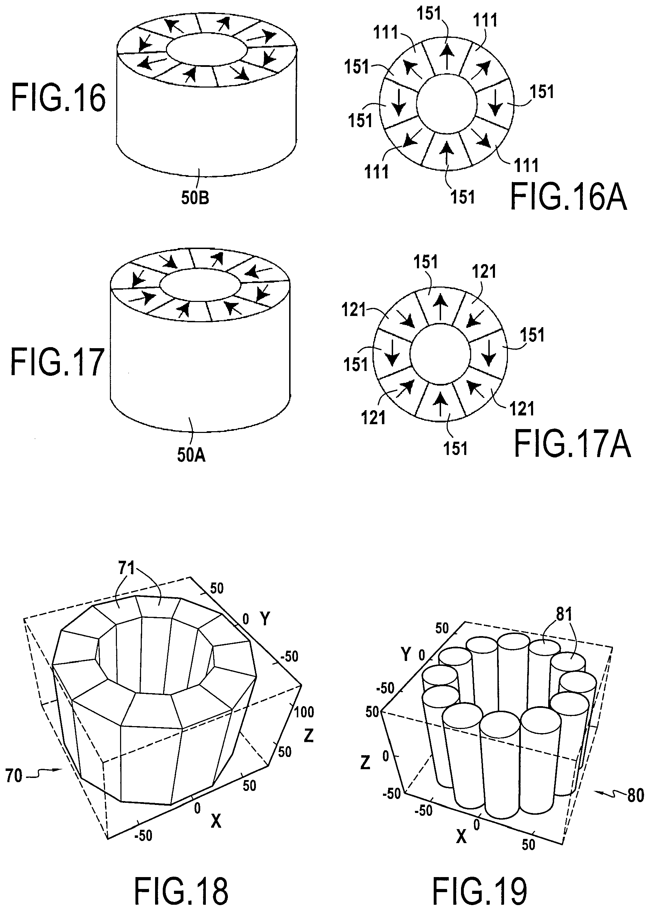

Les couronnes 10, 20, 30, 40, 50 peuvent être divisées en éléments constitutifs élémentaires qui constituent des secteurs angulaires de cylindre, mais ces couronnes peuvent également présenter une forme prismatique avec une section de forme polygonale. D'une façon générale, une couronne « pure », peut être constituée d'éléments constitutifs individuels en forme de secteurs identiques régulièrement répartis et dont la section perpendiculaire à l'axe longitudinal z peut présenter des formes variées (par exemple la forme d'un trapèze isocèle comme les éléments 71 de la couronne « pure » 70 représentée sur la figure 18 ou la forme d'un cercle comme les éléments 81 de la couronne « pure » 80 représentée sur la figure 19, mais d'autres formes sont également possibles). Ces secteurs sont avantageusement jointifs mais peuvent également présenter entre eux de petits intervalles vides qui permettent le repositionnement ou l'ajustement des secteurs pour une optimisation de l'uniformité du champ. Les exemples de réalisation des figures 18 et 19 montrent des couronnes 70, 80 avec des secteurs jointifs. Ces secteurs ont comme propriété importante d'avoir une aimantation uniforme dans leur volume pour précisément faciliter leur réalisation.

Il est à noter que l'avantage principal des secteurs cylindriques est qu'ils sont tous identiques pour une structure de type Halbach, avec en plus la possibilité d'un réglage de l'orientation de l'aimantation dans l'arrangement final ce qui constitue un avantage important des modes de réalisation de l'invention utilisant des éléments constitutifs individuels cylindriques. Les réglages pour obtenir l'homogénéité désirée sont ainsi simplifiés.

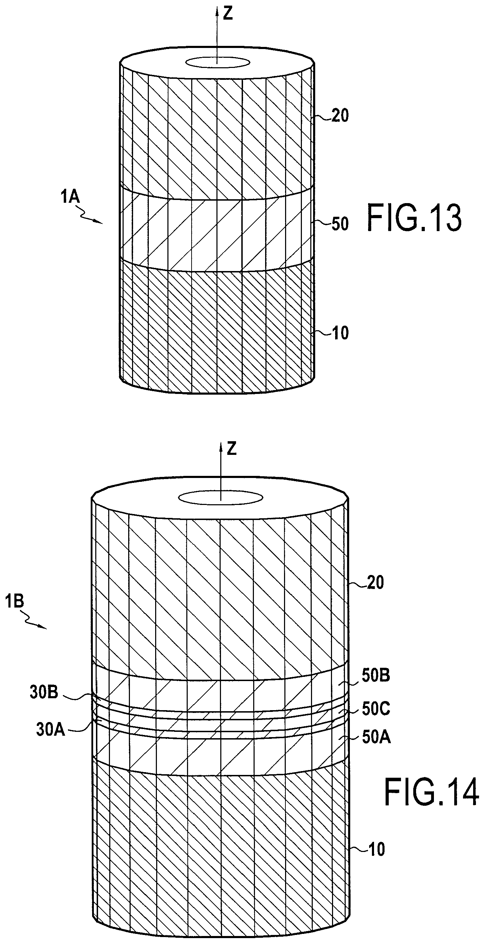

La structure de la figure 1 est symétrique par rapport à un plan P perpendiculaire à l'axe longitudinal z. On a représenté à titre d'exemple un empilement d'une couronne 10 à aimantation radiale divergente, d'une première couronne 50A à aimantation de variation continue de type dipolaire de Halbach, d'une première couronne 30A à aimantation longitudinale parallèle à l'axe z, d'une deuxième couronne 30B à aimantation longitudinale parallèle à l'axe z, d'une deuxième couronne 50B à aimantation de variation continue de type dipolaire de Halbach, et d'une couronne 20 à aimantation radiale convergente. A titre de variante, une paire de couronnes symétriques par rapport au plan P et présentant une aimantation longitudinale antiparallèle à l'axe z (comme la couronne 40 de la figure 6) pourraient également être incluses dans l'empilement de la figure 1. Sur la figure 1, pour plus de clarté, les différentes couronnes empilées sont disjointes, mais en pratique, les couronnes aimantées 10 et 20 ainsi que l'ensemble des couronnes aimantées 30A, 30B, 50A, 50B (et éventuellement une paire de couronnes aimantées 40) constituant une structure aimantée annulaire médiane sont plus généralement jointives selon l'axe longitudinal z (comme cela est représenté sur les figures 13 à 15 qui seront décrites plus loin).

Du fait que la fabrication de la structure aimantée essentiellement axisymétrique selon l'invention implique l'assemblage de secteurs, selon un deuxième mode de réalisation représenté sur la figure 2, la structure aimantée quasi-axisymétrique 2 est fabriquée à partir de couronnes « hybrides » aimantées qui sont construites à partir de secteurs constituant des portions des couronnes 10, 20, 30, 40, 50 représentées sur les figures 3 à 7.

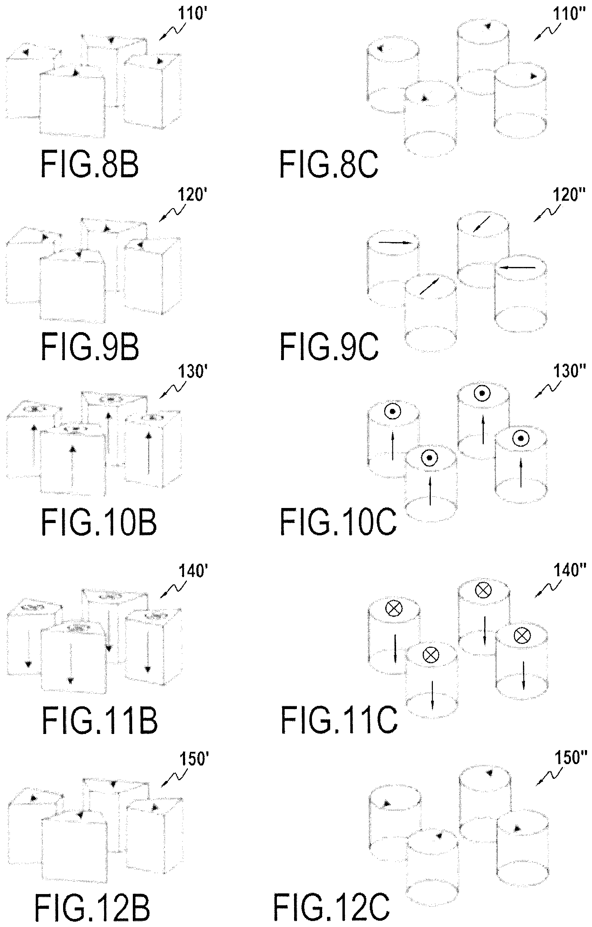

Ainsi, les figures 8A, 8B, 8C, montrent des ensembles de secteurs individuels 110, 110', 110" qui correspondent à la distribution d'aimantation (radiale divergente) de la couronne 10 de la figure 3.

Les figures 9A, 9B, 9C, montrent des ensembles de secteurs individuels 120, 120', 120" qui correspondent à la distribution d'aimantation (radiale convergente) de la couronne 20 de la figure 4.

Les figures 10A, 10B, 10C, montrent des ensembles de secteurs individuels 130, 130', 130" qui correspondent à la distribution d'aimantation (longitudinale parallèle à l'axe z) de la couronne 30 de la figure 5.

Les figures 11A, 11B, 11C, montrent des ensembles de secteurs individuels 140, 140', 140" qui correspondent à la distribution d'aimantation (longitudinale antiparallèle à l'axe z) de la couronne 40 de la figure 6.

Les figures 12A, 12B, 12C, montrent des ensembles de secteurs individuels 150, 150', 150" qui correspondent à la distribution d'aimantation (de variation continue de type dipolaire de Halbach) de la couronne 50 de la figure 7.

Pour construire une couronne "hybride" on prend des secteurs tels que ceux qui sont montrés sur les figures 8A à 12A, 8B à 12B ou 8C à 12C, et ceux-ci sont imbriqués de manière alternée, c'est-à-dire que un sur deux provient d'une distribution d'aimantation différente.

Du fait que les secteurs imbriqués correspondent à des distributions d'aimantation différentes, leur épaisseur peut être aussi différente. Ceci se voit facilement sur l'assemblage final 2 montré sur la figure 2 à titre d'exemple où l'on voit une première couronne hybride comprenant des secteurs d'un ensemble 110 d'éléments à aimantation radiale divergente de la figure 8A qui alternent avec des secteurs d'un ensemble 150A d'éléments à aimantation de Halbach de la figure 12A, puis une autre couronne hybride comprenant des secteurs d'un ensemble 140A d'éléments à aimantation longitudinale antiparallèle de la figure 11A qui alternent avec des secteurs de l'ensemble 150A d'éléments à aimantation de Halbach de la figure 12A, puis une autre couronne hybride comprenant des secteurs d'un ensemble 130A d'éléments à aimantation longitudinale parallèle de la figure 10A qui alternent avec des secteurs d'un autre ensemble 150C d'éléments à aimantation de Halbach de la figure 12A, puis encore une autre couronne hybride comprenant des secteurs d'un autre ensemble 130B d'éléments à aimantation longitudinale parallèle de la figure 10A qui alternent avec des secteurs de l'ensemble 150C d'éléments à aimantation de Halbach de la figure 12A, puis encore une autre couronne hybride comprenant des secteurs d'un ensemble 140B d'éléments à aimantation longitudinale antiparallèle de la figure 11A qui alternent avec des secteurs de l'ensemble 150C d'éléments à aimantation de Halbach de la figure 12A, puis enfin une dernière couronne hybride comprenant des secteurs d'un ensemble 120 d'éléments à aimantation radiale convergente de la figure 9A qui alternent avec des secteurs d'un ensemble 150B d'éléments à aimantation de Halbach de la figure 12A.

Le choix des secteurs à imbriquer se fait de manière à former deux composantes de champ, arbitrairement homogènes indépendamment au centre de la structure, et dont l'orientation est essentiellement orthogonale. Les amplitudes des deux champs sont choisies pour obtenir un champ résultant qui pointe à un angle bien précis par rapport à l'axe de la structure.

A titre d'exemple les figures 16 et 16A montrent une couronne hybride telle que celle illustrée sur la figure 2 avec un ensemble 150B de secteurs à aimantation de Halbach comprenant des secteurs individuels 151 dont l'aimantation correspond à l'orientation selon le dipôle de Halbach et qui alternent avec des secteurs individuels 111 dont l'aimantation est orientée radialement de façon divergente.

De façon similaire, les figures 17 et 17A montrent une couronne hybride telle que celle illustrée sur la figure 2 avec un ensemble 150A de secteurs à aimantation de Halbach comprenant des secteurs individuels 151 dont l'aimantation correspond à l'orientation selon le dipôle de Halbach et qui alternent avec des secteurs individuels 121 dont l'aimantation est orientée radialement de façon convergente.

L'empilement des deux couronnes hybrides des figures 16 et 17 permet de créer un champ total au sein de la structure d'ensemble qui fait un angle prédéterminé avec l'axe longitudinal z.

Si l'on considère les figures 1 et 2, on voit ainsi dans chaque cas une structure aimantée qui est un assemblage d'éléments cylindriques annulaires constituant des aimants permanents. Ces éléments annulaires sont alignés selon un même axe longitudinal z et sont symétriques par rapport au plan P. Le centre de la région d'intérêt où doit être créé un champ intense et homogène est situé à l'intersection de l'axe z et du plan P. La structure d'ensemble est cylindrique avec un trou central qui s'étend le long de l'axe z et permet d'accéder au centre de la région d'intérêt.

La symétrie par rapport au plan P permet d'annuler tous les termes impairs dans le développement en harmoniques sphériques solides réguliers de la composante $B_z$ du champ magnétique produit au voisinage du centre de la zone d'intérêt.

Dans le mode de réalisation des figures 18 et 19, le nombre de douze secteurs par anneau constitue un mode de réalisation préférentiel avec un ordre d'homogénéité satisfaisant. Un nombre de secteurs inférieur, par exemple dix secteurs ou même moins, permet également des résultats utiles, mais avec une homogénéité légèrement dégradée. Si l'on souhaite améliorer encore plus l'homogénéité, on peut diviser chaque tranche en plus de douze secteurs.

On décrira brièvement ci-dessous quelques notions de base utiles à la compréhension de l'invention.

Dans la plupart des cas, la région d'intérêt (RoI) est en dehors de la région des sources de champ magnétique et l'on peut définir un potentiel magnétique pseudo-scalaire tel que :

$$\vec{B} = -\vec{\nabla}\Phi^*$$

Ce potentiel vérifie l'équation de Laplace:

$$\Delta\Phi^* = 0$$

Dans le cas qui nous intéresse, on peut représenter la région d'intérêt comme une sphère dont le centre sera appelé l'origine. L'équation de Laplace peut s'exprimer dans un système de coordonnées sphériques et l'on peut obtenir un développement unique du potentiel en harmoniques sphériques, centré sur l'origine. La solution générale pour le potentiel peut alors s'écrire :

$$\Phi^*(r,\theta,\phi) = \sum_{l=0}^{\infty}\sum_{m=-l}^{l}\left[A_{lm}r^l + B_{lm}r^{-(l+1)}\right]Y_{lm}(\theta,\phi),$$

où:

$$Y_{lm}(\theta,\phi) = \sqrt{\frac{2l+1}{4\pi}\frac{(l-m)!}{(l+m)!}}P_l^m(\cos\theta)\exp(im\phi)$$

On peut retenir que le potentiel existe seulement dans les zones vides de l'espace. On peut diviser l'espace en deux zones où le potentiel existe : à l'intérieur de la plus grande sphère centrée sur l'origine qui ne contient aucune source et à l'extérieur de la plus petite sphère centrée sur l'origine qui contient toutes les sources.

Lorsque les sources sont situées à l'extérieur de cette sphère, on peut écrire le développement de la façon suivante :

$$\Phi^*(r,\theta,\phi) = \frac{1}{\mu_0}\left\{Z_0 + \sum_{n=1}^{\infty}r^n\left[Z_nP_n(\cos\theta) + \sum_{m=1}^{n}\left(X_n^m\cos(m\phi) + Y_n^m\sin(m\phi)\right)P_n^m(\cos\theta)\right]\right\}$$

Où les termes $Z_n$ sont appelés les termes axiaux et les termes $X_n^m$ et $Y_n^m$ sont appelés les termes non-axiaux.

Toutefois, on est surtout intéressé par le champ créé par la structure. Les trois composantes du champ en coordonnées cartésiennes satisfont à l'équation de Laplace et peuvent faire l'objet de développements de la même manière que le potentiel.

Dans le contexte de la présente invention on peut considérer les composantes Bx et Bz de l'induction du champ magnétique selon un axe x orthogonal à la direction longitudinale z et selon cet axe longitudinal z respectivement, et on peut écrire :

$$B_x(r,\theta,\phi) = Zx_0 + \sum_{n=1}^{\infty} r^n \left[ Zx_n P_n(\cos\theta) + \sum_{m=1}^{n} \left( Xx_n^m \cos(m\phi) + Yx_n^m \sin(m\phi) \right) P_n^m(\cos\theta) \right]$$

$$B_z(r,\theta,\phi) = Zz_0 + \sum_{n=1}^{\infty} r^n \left[ Zz_n P_n(\cos\theta) + \sum_{m=1}^{n} \left( Xz_n^m \cos(m\phi) + Yz_n^m \sin(m\phi) \right) P_n^m(\cos\theta) \right]$$

Avec des relations spécifiques entre $Zx_n$, $Xx_n^m$, $Yx_n^m$, $Zz_n$, $X_{zn}^m$, $Yz_n^m$ et $Z_n$, $Xn^m$, $Y_n^m$ à partir du potentiel. Il en résulte qu'il est nécessaire de traiter séparément les composantes x et z du champ.

Dans le cas de $B_z$, ces relations sont simples: $Zz_n$, $Xz_n^m$ and $Yz_n^m$ sont respectivement proportionnels à $Z_{n+1}$, $X_{n+1}^m$, $Y_{n+1}^m$.

A partir de cette équation, on peut conclure que pour obtenir un champ homogène, il faut trouver une distribution de la source qui crée un potentiel pour lequel le développement ne contient que le terme $Z_1$ (dès lors que le champ est la dérivée du potentiel et que le terme $Z_0$ pour le champ correspond au terme $Z_1$ pour le potentiel). Ceci est impossible au sens strict, mais on peut supprimer autant de termes que nécessaire pour obtenir l'homogénéité désirée dans un rayon r donné puisque le champ varie comme $\left(\dfrac{r}{a}\right)^n$ où a est une constante caractéristique de la géométrie. En conclusion, pour obtenir l'homogénéité souhaitée, il faut supprimer les k premiers ordres jusqu'à ce que $\left(\dfrac{r}{a}\right)^{k+1}$ soit suffisamment petit.

De cette équation on peut aussi déduire qu'une structure axisymétrique est avantageuse dans la mesure où elle supprime les termes non axiaux. Si l'on veut obtenir une homogénéité de l'ordre n, la symétrie de rotation en n+1 garantit qu'aucun terme non axial n'existe avant l'ordre n.

Une fois que les termes non axiaux ont été éliminés, il reste les termes axiaux.

Une autre symétrie intéressante est l'antisymétrie par rapport au plan xOy qui ne laisse que les termes axiaux impairs dans le potentiel et donc que les termes axiaux pairs dans le champ. L'antisymétrie peut aussi servir pour les termes non axiaux en permettant l'utilisation d'une symétrie de rotation en n pour obtenir l'ordre n. Il est alors possible d'éliminer arbitrairement les ordres 2p en agençant p+1 sources indépendantes.

Dans le cas de $B_x$, la relation avec le potentiel est moins immédiate. On a:

$$Xx_n^1 = Z_{n+1} - \frac{(n+m+1)(n+m+2)}{2} X_{n+1}^2 \ \forall n \geq 1$$

$$Xx_n^m = \frac{1}{2} X_{n+1}^{m-1} - \frac{(n+m+1)(n+m+2)}{2} X_{n+1}^{m+1} \ \forall n \geq 2,\ 2 \leq m \leq n$$

$$Yx_n^1 = -\frac{(n+2)(n+3)}{2} Y_{n+1}^2 \forall n \geq 1$$

$$Yx_n^m = \frac{1}{2} Y_{n+1}^{m-1} - \frac{(n+m+1)(n+m+2)}{2} Y_{n+1}^{m+1} \forall n \geq 2, 2 \leq m \leq n$$

$$Zx_n = -\frac{(n+1)(n+2)}{2} X_{n+1}^1 \forall n \geq 0$$

Au total, la symétrie cylindrique en n permet l'élimination des termes axiaux pour $B_x$ et l'élimination de la plupart des termes non-axiaux jusqu'à l'ordre n-1. L'utilisation de p+1 sources permet l'élimination de $Xx_n^1$ jusqu'à l'ordre p.

Toutefois, dans une structure du type Halbach, la distribution de potentiel ne présente pas une symétrie de rotation en n, de telle sorte que les termes non-axiaux du potentiel ne sont pas automatiquement éliminés. En dépit de ce manque de symétrie, les termes non-axiaux de $B_x$ sont éliminés jusqu'à l'ordre n-2 pour une structure du type Halbach utilisant n segments. En fonction de la géométrie, le premier ordre non-nul peut rester très faible. La symétrie xOy élimine chaque terme pair dans le potentiel, de sorte qu'il ne reste que des termes axiaux pairs (du fait que $Zx_n$ est proportionnel à $X_{n+1}^1$).

En résumé, on obtient une composante transverse homogène d'ordre 2p avec l'utilisation de structures du type de Halbach comprenant 2p+2 segments et p+1 tranches placées de façon symétrique autour du plan xOy.

A partir des formules analytiques du développement pour les géométries de différentes sources, on peut réaliser une optimisation non-linéaire qui conduit à une solution correcte.

Par ailleurs la solution trouvée est extensible. Le système peut être étendu de façon uniforme dans toutes les dimensions (de façon homothétique) et peut être rendu aussi grand que possible, les propriétés d'homogénéité n'étant pas affectées et l'amplitude du champ magnétique restant constante.

On décrira maintenant à titre d'exemples différents modes de réalisation possibles de la présente invention.

L'invention permet d'obtenir un champ fort et très homogène qui pointe essentiellement à l'angle magique (~54.7°) par rapport à l'axe de symétrie de l'aimant, mais ceci n'est pas restrictif et l'invention s'applique à d'autres situations où le champ est plus faible ou fait un angle différent. Dans l'exemple d'aimant à champ incliné 1A illustré sur la figure 13, on utilise un empilement de trois couronnes « pures » 10, 50 et 20. La couronne 20 a une distribution d'aimantation radiale vers le trou de l'aimant (voir Fig. 4), la couronne 10 a une distribution d'aimantation radiale vers la surface extérieure de l'aimant (voir Fig. 3) et la couronne intermédiaire 50 a une distribution d'aimantation dont l'orientation varie comme dans les dipôles de Halbach (voir la Fig. 7). Il n'y a pas d'intervalle libre le long de l'axe z entre les trois composantes 10, 20, 50. Le champ total généré au centre de l'aimant est de $\sim 0.989\mu_0 M$, où $\mu_0 M$ représente l'aimantation des pièces aimantées et pointe à l'angle magique.

Dans l'exemple d'aimant à champ incliné 1B illustré sur la figure 14, on utilise un empilement de sept couronnes « pures » 10, 50A, 30A, 50C, 30B, 50B et 20. La couronne 20 a une distribution d'aimantation radiale vers le trou central de l'aimant (voir la Fig. 4), la couronne 10 a une distribution d'aimantation radiale vers la surface extérieure de l'aimant (voir la Fig. 3). Les couronnes 50A, 50C, 50B ont une distribution d'aimantation dont l'orientation varie comme dans les dipôles de Halbach (voir la Fig 7). Les deux couronnes 30A et 30B intercalées entre les couronnes 50A, 50C et 50B respectent une symétrie par rapport à un plan perpendiculaire à l'axe longitudinal z et ont une aimantation à orientation axiale parallèle à l'axe z (voir la Fig. 5). Il n'y a pas d'intervalle libre le long de l'axe z entre les différentes couronnes constituant l'aimant 1B. Le champ généré au centre de l'aimant est de $\sim 0.889\mu_0 M$, où $\mu_0 M$ représente l'aimantation des pièces aimantées. L'aimant est homogène à l'ordre 4 L'orientation du champ au centre de l'aimant fait l'angle magique avec une déviation inférieure au 1/1000 dans la région d'intérêt.

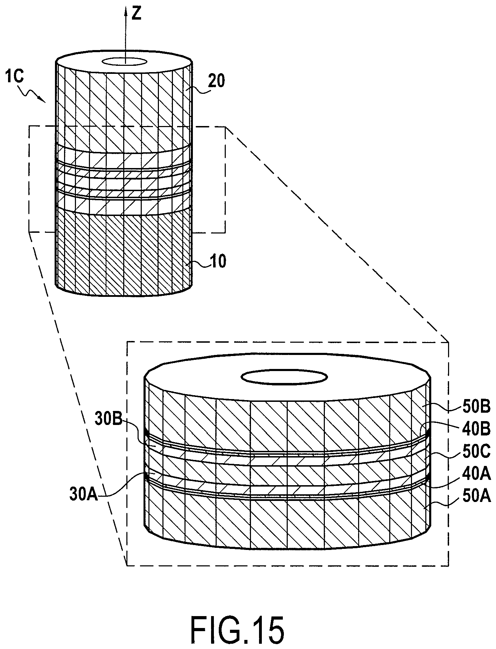

Dans l'exemple d'aimant à champ incliné 1C illustré sur la figure 15, on utilise un empilement de onze couronnes « pures » 10, 50A, 40A, 30A, 50C, 30B, 40B, 50B. La couronne 20 a une distribution d'aimantation radiale vers le trou central de l'aimant (voir la Fig. 4), la couronne 10 a une distribution d'aimantation radiale vers la surface extérieure de l'aimant (voir la Fig. 3). Les couronnes 50A, 50C, 50B ont une distribution d'aimantation dont l'orientation varie comme dans les dipôles de Halbach (voir la Fig. 7). Les deux couronnes 30A, 30B ont une aimantation à orientation axiale parallèle à l'axe z (voir la Fig. 5), tandis que les composantes 40A, 40B ont une aimantation à orientation axiale anti-parallèle à l'axe z (voir la Fig. 6).

Il n'y a pas d'intervalle libre le long de l'axe z entre les différentes couronnes de l'empilement et le champ total généré au centre de l'aimant est de $\sim 0.862\mu_0 M$, ou $\mu_0 M$ représente l'aimantation des pièces aimantées. Dans l'exemple représenté sur la figure 15, les couronnes 40A, 30A et 40B, 30B interposées respectivement entre les couronnes 50A et 50C et 50B et 50C sont symétriques par rapport à un plan perpendiculaire à l'axe z. Les couronnes 40A, 40B à aimantation longitudinale antiparallèle présentent une épaisseur inférieure à celle des couronnes 30A, 30B à aimantation longitudinale parallèle, tandis que l'épaisseur des couronnes 30A, 30B est elle-même inférieure à celle des couronnes 50A, 50B, et l'épaisseur des couronnes 50A, 50B est elle-même inférieure à celle des couronnes 10, 20 à aimantation radiale. Toutefois, des configurations différentes sont possibles avec d'autres épaisseurs de couronne configuration. L'aimant 1C est homogène à l'ordre 6. L'orientation du champ au centre de l'aimant fait l'angle magique avec une déviation inférieure au 1/10000 dans la région d'intérêt.

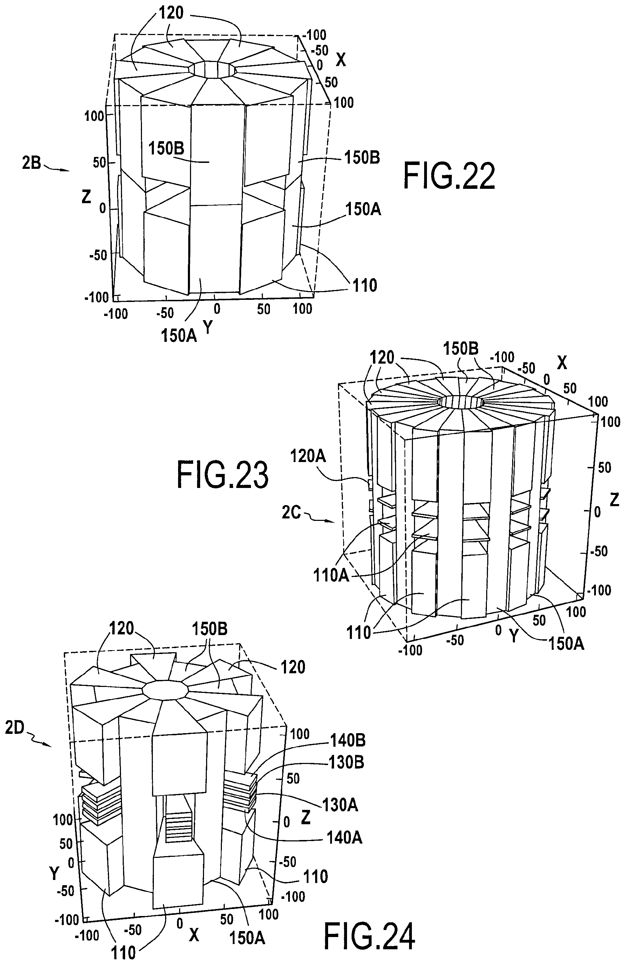

Dans l'exemple d'aimant à champ incliné 2B illustré sur la figure 22, on utilise deux couronnes « hybrides ». Les secteurs de l'ensemble 120 ont une aimantation radiale vers le trou central de l'aimant (voir la Fig. 9B), les secteurs de l'ensemble 110 ont une aimantation radiale vers la surface extérieure de l'aimant (voir la Fig. 8B) et les secteurs des ensembles 150A, 150B ont une aimantation dont l'orientation varie comme dans les dipôles de Halbach (voir la Fig. 12B). Les secteurs des ensembles 110 et 120 sont responsables pour la fabrication de la composante longitudinale du champ magnétique, tandis que les secteurs des ensembles 150A, 150B qui sont imbriqués avec les secteurs des ensembles 110 et 120 respectivement pour former des couronnes hybrides fabriquent la composante transverse.

On voit qu'un espace libre peut être ménagé dans le sens axial entre les secteurs de l'ensemble 110 et les secteurs de l'ensemble 120, tandis que les secteurs des ensembles 150A et 150B sont jointifs selon l'axe z, et l'épaisseur des secteurs des ensembles 110 et 120 est différente de celle des secteurs des ensembles 150A et 150B, mais des configurations différentes sont possibles.

Le champ total généré au centre de l'aimant est de ~0.731$\mu_0$M, où $\mu_0$M représente l'aimantation des pièces aimantées. Le champ magnétique au centre de l'aimant 2B pointe essentiellement à l'angle magique. L'ordre d'homogénéité de cet aimant est 4 (4ème ordre en longitudinal et 4ème ordre en transverse).

Dans l'exemple d'aimant à champ incliné de grande homogénéité 2C illustré sur la figure 23, on utilise des secteurs comme ceux des figures 8B, 9B, 12B pour faire des couronnes « hybrides ». Les secteurs des ensembles 120, 120A ont une aimantation radiale vers le trou central de l'aimant (voir la Fig. 9B), les secteurs des ensembles 110, 110A ont une aimantation radiale vers la surface extérieure de l'aimant (voir la Fig. 8B) et les secteurs des ensembles 150A, 150B ont une aimantation dont l'orientation varie comme dans les dipôles de Halbach (voir la Fig. 12B).

Il n'y a pas d'intervalle libre entre les différents secteurs, mais il y a une alternance des secteurs des ensembles 150A et 150B d'une part et des secteurs des ensembles 110, 110A et 120, 120A d'autre part. La configuration de la figure 23 se distingue de celle de la figure 22 essentiellement par le fait que les ensembles de secteurs 110, 110A d'une part et 120, 120A d'autre part sont divisés en tranches le long de l'axe z, avec des tranches plus fines 110A, 120A dans la partie médiane de l'aimant et une configuration symétrique des ensembles 110, 10A et 120, 120A par rapport à un plan perpendiculaire à l'axe z.

Le champ total généré au centre de l'aimant est de -0.732 $\mu_0$M, où $\mu_0$M représente l'aimantation des pièces aimantées. Le champ magnétique pointe essentiellement à l'angle magique. L'ordre d'homogénéité de cet aimant est 6 (6ème ordre en longitudinal et 6ème ordre en transverse).

Dans l'exemple d'aimant à champ incliné 2D illustré sur la figure 24, qui présente une grande homogénéité, on utilise des secteurs comme ceux des figures 8B, 9B, 10B, 11B, 12B pour faire des couronnes « hybrides ». Les secteurs de l'ensemble 120 ont une distribution d'aimantation radiale vers le trou central de l'aimant (voir la Fig 9B), les secteurs de l'ensemble 110 ont une distribution d'aimantation radiale vers la surface extérieure de l'aimant (voir la Fig 8B) et les secteurs des ensembles 150A, 150B ont une distribution d'aimantation dont l'orientation varie comme dans les dipôles de Halbach (voir la Fig 12B).

On voit en outre, étagés le long de l'axe z entre les ensembles de secteurs 110 et 120 et entre les secteurs des ensembles 150A, 150B, des secteurs de deux ensembles 130A et 130B symétriques par rapport à un plan perpendiculaire à l'axe z, ces secteurs ayant une aimantation longitudinale parallèle à l'axe z (voir la figure 10B). On voit également de façon similaire et de part et d'autre des ensembles 130A, 130B, des secteurs de deux ensembles 140A et 140B symétriques par rapport à un plan perpendiculaire à l'axe z, ces secteurs ayant une aimantation longitudinale antiparallèle à l'axe z (voir la figure 11B). Les secteurs des ensembles 130A, 130B, 140A et 140B présentent des épaisseurs de préférence beaucoup plus réduites que celles des secteurs des ensembles 110, 120, 150A et 150B.

Le champ total généré au centre de l'aimant est de ~0.7$\mu_0$M, où $\mu_0$M représente l'aimantation des pièces aimantées. Le champ magnétique pointe essentiellement à l'angle magique (mais d'autres orientations seraient naturellement possibles comme pour les autres modes de réalisation décrits). L'ordre d'homogénéité de l'aimant 2D est 6 (6ème ordre en longitudinal et 6ème ordre en transverse).

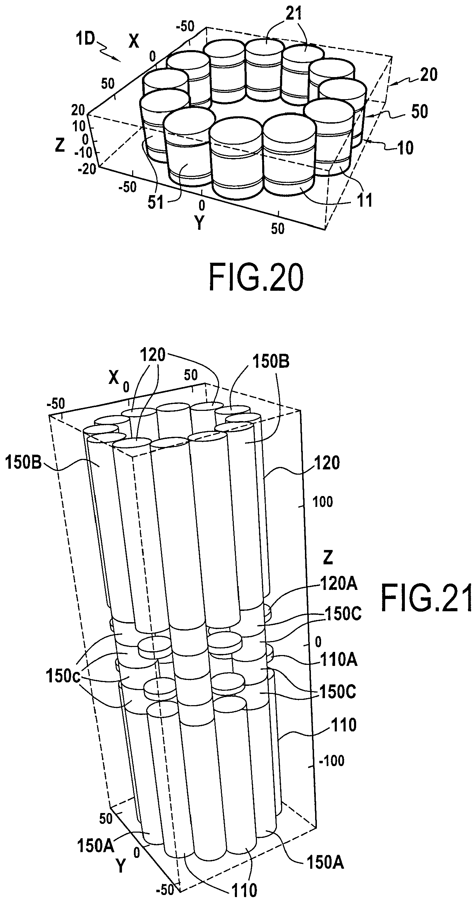

Dans l'exemple d'aimant à champ incliné 1D illustré sur la figure 20, on utilise trois couronnes « pures » 10, 50, 20, qui sont cette fois constituées de cylindres 11, 51, 21 respectivement. La couronne 20 a une distribution d'aimantation radiale vers le trou central de l'aimant, la couronne 10 a une distribution d'aimantation radiale vers la surface extérieure de l'aimant et la couronne 50 a une distribution d'aimantation dont l'orientation varie comme dans les couronnes de Halbach. L'avantage incontestable de cette construction avec des secteurs cylindriques est que ceux-ci (voir les figures 8C, 9C, 12C) sont tous identiques pour une structure de type Halbach, avec en plus la possibilité d'un réglage de l'orientation de l'aimantation dans l'arrangement final.

Dans l'exemple d'aimant à champ incliné illustré sur la figure 21, on utilise des secteurs cylindriques alternés, comme ceux des figures 8C, 9C, 10C, 11C, 12C, pour faire des couronnes « hybrides ». Les secteurs des ensembles 120, 120A ont une distribution d'aimantation radiale vers le trou de l'aimant (voir la Fig 9C), les secteurs des ensembles 110, 110A ont une distribution d'aimantation radiale vers la surface extérieure de l'aimant (voir la Fig. 8C) et les secteurs des ensembles 150A, 150B et 150C ont une distribution d'aimantation dont l'orientation varie comme dans les dipôles de Halbach.

Comme dans le mode de réalisation de la figure 23, les ensembles de secteurs 110, 110A d'une part et 120, 120A d'autre part sont divisés en tranches le long de l'axe z, avec des tranches plus fines 110A, 120A dans la partie médiane de l'aimant et une configuration symétrique des ensembles 110, 110A et 120, 120A par rapport à un plan perpendiculaire à l'axe z. Il n'y a pas d'intervalle libre entre les différents secteurs, mais il y a une alternance de secteurs des ensembles 150A et 150B d'une part et des secteurs des ensembles 110, 110A et 120, 120A d'autre part. Les secteurs des ensembles 110 et 120 sont responsables pour la fabrication de la composante longitudinale du champ magnétique, tandis que les secteurs des ensembles 150A, 150B qui sont imbriqués avec les secteurs des ensembles 110 et 120 respectivement pour former des couronnes hybrides fabriquent la composante transverse. On voit qu'un espace libre peut être ménagé dans le sens axial entre les secteurs des ensembles 110, 110A et les secteurs des ensembles 120, 120A tandis que les secteurs des ensembles 150A,150B et 150C sont jointifs selon l'axe z,

Le champ total généré au centre de l'aimant est de $\sim0.229\mu_0M$, où $\mu_0M$ représente l'aimantation des pièces aimantées. Dans cet exemple, le champ magnétique pointe à 59 degrés. L'ordre d'homogénéité de cet aimant est 6 (6ème ordre en longitudinal et 6ème ordre en transverse).

Diverses modifications et adjonctions sont possibles sans sortir du cadre de l'invention. En particulier, les différents modes de réalisation décrits peuvent se combiner entre eux. Par ailleurs, il a été fait référence à des structures présentant une distribution d'aimantation dont l'orientation varie comme dans les dipôles de Halbach, afin de provoquer une inclinaison du champ magnétique. L'invention prend en compte également à titre d'équivalence d'autres distributions d'aimantations dipolaires susceptibles de provoquer la même inclinaison du champ, telles que par exemple les structures décrites dans le brevet US 4 999 600.

**Revendications**

1. Structure aimantée induisant un champ magnétique homogène pour un appareil de Résonance Magnétique Nucléaire, comprenant un assemblage de pièces aimantées avec au moins des première et deuxième couronnes aimantées (10, 20) disposées de façon symétrique par rapport à un plan (P) qui est perpendiculaire à un axe longitudinal (z) et contient une zone d'intérêt centrale, et au moins une structure aimantée annulaire médiane interposée au moins partiellement entre les première et deuxième couronnes aimantées (10, 20) et également disposée de façon symétrique par rapport audit plan (P), la première couronne aimantée (10) étant aimantée radialement par rapport à l'axe longitudinal (z) avec une aimantation divergente, la deuxième couronne aimantée (20) étant aimantée radialement par rapport à l'axe longitudinal (z) avec une aimantation convergente, et la structure aimantée annulaire médiane étant aimantée avec une orientation différente de celle de l'aimantation des première et deuxième couronnes aimantées (10, 20), **caractérisée en ce que** la structure aimantée annulaire médiane comprend au moins une couronne aimantée (50) présentant une distribution d'aimantation dont l'orientation varie comme dans les dipôles de Halbach, **en ce que** les première et deuxième couronnes aimantées (10, 20) ainsi que la structure aimantée annulaire médiane sont divisées chacune en éléments constitutifs individuels en forme de secteurs identiques régulièrement répartis (71, 81), **en ce que** lesdits éléments constitutifs individuels des couronnes pures des première et deuxième couronnes aimantées (10, 20) ainsi que de la structure aimantée annulaire médiane excepté ladite au moins une couronne aimantée (50) présentant une distribution d'aimantation dont l'orientation varie comme dans les dipôles de Halbach, présentent une même distribution d'aimantation, et **en ce que** les première et deuxième couronnes aimantées (10, 20) ainsi que la structure aimantée annulaire médiane sont jointives selon l'axe longitudinal (z).

2. Structure aimantée selon la revendication 1, **caractérisée en ce que** les éléments constitutifs individuels en forme de secteurs identiques régulièrement répartis (71, 81) constituant une couronne pour chacune des première et deuxième couronnes aimantées (10, 20) ainsi que pour la structure aimantée annulaire médiane sont au moins au nombre de douze par couronne.

3. Structure aimantée selon l'une quelconque des revendications 1 et 2, **caractérisée en ce que** la structure annulaire médiane comprise entre les première et deuxième couronnes aimantées (10, 20) comprend en outre au moins deux couronnes aimantées (30A, 30B) symétriques par rapport audit plan (P) perpendiculaire à l'axe longitudinal (z) et présentant une aimantation à orientation axiale parallèle audit axe longitudinal (z) dans le sens positif dudit axe longitudinal.

4. Structure aimantée selon l'une quelconque des revendications 1 à 3, **caractérisée en ce que** la structure annulaire médiane comprise entre les première et deuxième couronnes aimantées (10, 20) comprend en outre au moins deux couronnes aimantées (40A, 40B) symétriques par rapport audit plan (P) perpendiculaire à l'axe longitudinal (z) et présentant une aimantation à orientation axiale antiparallèle audit axe longitudinal (z).

5. Structure aimantée selon l'une quelconque des revendications 1 à 4, **caractérisée en ce que** tous les éléments constitutifs individuels constituant une couronne présentent une section constituée par un secteur de couronne cylindrique.

6. Structure aimantée selon l'une quelconque des revendications 1 à 4, **caractérisée en ce que** tous les éléments constitutifs individuels constituant une couronne présentent une section de forme trapézoïdale (71).

7. Structure aimantée selon l'une quelconque des revendications 1 à 4, **caractérisée en ce que** tous les éléments constitutifs individuels constituant une couronne présentent une section en forme de disque (81).

8. Structure aimantée induisant un champ magnétique homogène pour un appareil de Résonance Magnétique Nucléaire, comprenant un assemblage de pièces aimantées avec au moins des première et deuxième couronnes aimantées (110, 120) disposées de façon symétrique par rapport à un plan (P) qui est perpendiculaire à un axe longitudinal (z) et contient une zone d'intérêt centrale, et au moins une structure aimantée annulaire médiane interposée au moins partiellement entre les première et deuxième couronnes aimantées (110, 120) et également disposée de façon symétrique par rapport audit plan (P), la première couronne aimantée (110) étant aimantée radialement par rapport à l'axe longitudinal (z) avec une aimantation divergente, la deuxième couronne aimantée (120) étant aimantée radialement par rapport à l'axe longitudinal (z) avec une aimantation convergente, et la structure aimantée annulaire médiane étant aimantée avec une orientation différente de celle de l'aimantation des première et deuxième couronnes aimantées (110, 120), **caractérisée en ce que** la structure aimantée annulaire médiane comprend au moins une couronne aimantée (150) présentant une distribution d'aimantation dont l'orientation varie comme dans les dipôles de Halbach, les première et deuxième couronnes aimantées (110, 120) ainsi que la structure aimantée annulaire médiane constituent des couronnes qui sont chacune divisées en éléments constitutifs individuels en forme de secteurs identiques régulièrement répartis, les éléments constitutifs individuels (151) de ladite au moins une couronne aimantée (150) présentant une distribution d'aimantation dont l'orientation varie comme dans les dipôles de Halbach étant au moins en partie imbriqués avec les éléments constitutifs individuels (111, 121) des première et deuxième couronnes aimantées (110, 120).

9. Structure aimantée selon la revendication 8, **caractérisée en ce que** la structure annulaire médiane comprise entre les première et deuxième couronnes aimantées (110, 120) comprend en outre au moins deux couronnes aimantées (130A, 130B) symétriques par rapport audit plan (P) perpendiculaire à l'axe longitudinal (z) et présentant une aimantation à orientation axiale parallèle audit axe longitudinal (z) dans le sens positif dudit axe longitudinal, **en ce que** la structure annulaire médiane comprise entre les première et deuxième couronnes aimantées (110, 120) comprend en outre au moins deux couronnes aimantées (140A, 140B) symétriques par rapport audit plan (P) perpendiculaire à l'axe longitudinal (z) et présentant une aimantation à orientation axiale antiparallèle audit axe longitudinal (z) et **en ce que** les éléments constitutifs individuels formant des couronnes aimantées (130A, 130B, 140A, 140B) symétriques audit plan (P) perpendiculaire à l'axe longitudinal (z) et présentant une aimantation à orientation axiale parallèle ou anti-parallèle audit axe longitudinal (z) sont imbriqués avec les éléments constitutifs individuels (151) de la couronne aimantée (150) présentant une distribution d'aimantation dont l'orientation varie comme dans les dipôles de Halbach.

10. Structure aimantée selon la revendication 8, **caractérisée en ce que** les première et deuxième couronnes aimantées (110, 120) constituant des couronnes qui sont chacune divisées en éléments constitutifs individuels en forme de secteurs identiques régulièrement répartis sont divisées en tranches le long de l'axe longitudinal (z), l'une au moins des tranches (110A, 120A) située le plus près dudit plan de symétrie (P) perpendiculaire audit axe longitudinal (z) présentant une épaisseur plus faible que les autres tranches.

11. Structure aimantée selon l'une quelconque des revendications 8 à 10, **caractérisée en ce que** les éléments constitutifs individuels (111, 121) des première et deuxième couronnes aimantées (110, 120) sont imbriqués dans le sens azimutal de façon alternée avec les éléments constitutifs individuels (151) de la couronne aimantée (150) présentant une distribution d'aimantation dont l'orientation varie comme dans les dipôles de Halbach.

**Patentansprüche**

1. Magnetisierte Struktur, die ein homogenes Magnetfeld für ein Kernspinresonanzgerät induziert, die eine Anordnung aus magnetisierten Teilen umfasst, mit mindestens einem ersten und einem zweiten magnetisierten Kranz (10, 20), die symmetrisch in Bezug zu einer Ebene (P), die zu einer Längsachse (z) senkrecht ist, angeordnet ist und einen zentralen Interessensbereich enthält, und mindestens eine mittlere ringförmige magnetisierte Struktur, die mindestens teilweise zwischen den ersten und den zweiten magnetisierten Kranz (10, 20) eingefügt und auch symmetrisch in Bezug zu der Ebene (P) angeordnet ist, wobei der erste magnetisierte Kranz (10) radial in Bezug zu der Längsachse (z) mit einer divergierenden Magnetisierung magnetisiert ist, der zweite magnetisierte Kranz (20) radial in Bezug zu der Längsachse (z) mit einer konvergierenden Magnetisierung magnetisiert ist, und die mittlere ringförmige magnetisierte Struktur mit einer Ausrichtung magnetisiert ist, die von der der Magnetisierung des ersten und zweiten magnetisierten Kranzes (10, 20) unterschiedlich ist, **dadurch gekennzeichnet, dass** die mittlere ringförmige magnetisierte Struktur mindestens einen magnetisierten Kranz (50) umfasst, der eine Magnetisierungsverteilung aufweist, deren Ausrichtung wie in den Halbach-Dipolen variiert, und dass der erste und der zweite magnetisierte Kranz (10, 20) sowie die mittlere ringförmige magnetisierte Struktur jeweils in einzelne Bestandselemente in Form regelmäßiger verteilter identischer Sektoren (71, 81) geteilt sind, und dass die einzelnen Bestandselemente der reinen Kränze des ersten und zweiten magnetisierten Kranzes (10, 20) sowie die mittlere ringförmige magnetisierte Struktur mit Ausnahme des mindestens einen magnetisierten Kranzes (50), der eine Magnetisierungsverteilung aufweist, deren Ausrichtung wie in den Halbach-Dipolen variiert, eine Magnetisierungsverteilung aufweisen, und dass der erste und der zweite magnetisierte Kranz (10, 20) sowie die mittlere ringförmige magnetisierte Struktur entlang der Längsachse (z) aneinander liegen.

2.  Magnetisierte Struktur nach Anspruch 1, **dadurch gekennzeichnet, dass** die einzelnen Bestandselemente in Form regelmäßig verteilter identischer Sektoren (71, 81), die einen Kranz für den ersten und zweiten magnetisierten Kranz (10, 20) sowie für die mittlere ringförmige magnetisierte Struktur bilden, pro Kranz mindestens zwölf sind.

3.  Magnetisierte Struktur nach einem der Ansprüche 1 und 2, **dadurch gekennzeichnet, dass** die mittlere ringförmige Struktur, die zwischen dem ersten und dem zweiten magnetisierten Kranz (10, 20) liegt, außerdem mindestens zwei magnetisierte Kränze (30A, 30B) umfasst, die in Bezug zu der Ebene (P), die zu der Längsachse (z) senkrecht ist, symmetrisch sind und eine Magnetisierung mit paralleler axialer Ausrichtung zu der Längsachse (z) in die positive Richtung der Längsachse aufweisen.

4.  Magnetisierte Struktur nach einem der Ansprüche 1 bis 3, **dadurch gekennzeichnet, dass** die mittlere ringförmige Struktur, die zwischen dem ersten und dem zweiten magnetisierten Kranz (10, 20) liegt, außerdem mindestens zwei magnetisierte Kränze (40A, 40B) umfasst, die in Bezug zu der Ebene (P), die zu der Längsachse (z) senkrecht ist, symmetrisch sind und eine Magnetisierung mit antiparalleler axialer Ausrichtung zu der Längsachse (z) aufweisen.

5.  Magnetisierte Struktur nach einem der Ansprüche 1 bis 4, **dadurch gekennzeichnet, dass** alle einzelnen Bestandselemente, die einen Kranz bilden, einen Querschnitt aufweisen, der durch einen zylindrischen Kranzsektor gebildet ist.

6.  Magnetisierte Struktur nach einem der Ansprüche 1 bis 4, **dadurch gekennzeichnet, dass** alle einzelnen Bestandselemente, die einen Kranz bilden, einen Querschnitt in Trapezform (71) aufweisen.

7.  Magnetisierte Struktur nach einem der Ansprüche 1 bis 4, **dadurch gekennzeichnet, dass** alle einzelnen Bestandselemente, die einen Kranz bilden, einen scheibenförmigen Querschnitt (81) aufweisen.

8.  Magnetisierte Struktur, die ein homogenes Magnetfeld für ein Kernspinresonanzgerät induziert, die eine Anordnung aus magnetisierten Teilen umfasst, mit mindestens einem ersten und einem zweiten magnetisierten Kranz (110, 120), die symmetrisch in Bezug zu einer Ebene (P), die zu einer Längsachse (z) senkrecht ist, angeordnet sind, und die einen zentralen Interessensbereich aufweist, und mindestens eine mittlere ringförmige magnetisierte Struktur, die mindestens teilweise zwischen dem ersten und dem zweiten magnetisierten Kranz (110, 120) eingefügt und auch symmetrisch in Bezug zu der Ebene (P) angeordnet ist, wobei der erste magnetisierte Kranz (110) in Bezug zu der Längsachse (z) radial mit einer divergierenden Magnetisierung magnetisiert ist, wobei der zweite magnetisierte Kranz (120) in Bezug zu der Längsebene (z) mit einer konvergierenden Magnetisierung magnetisiert ist, und die mittlere ringförmige magnetisierte Struktur mit einer Ausrichtung magnetisiert ist, die von der der Magnetisierung des ersten und zweiten Kranzes (110, 120) unterschiedlich ist, **dadurch gekennzeichnet, dass** die mittlere ringförmige magnetisierte Struktur mindestens einen magnetisierten Kranz (150) umfasst, der eine Magnetisierungsverteilung aufweist, deren Ausrichtung wie in den Halbach-Dipolen variiert, wobei der erste und zweite magnetisierte Kranz (110, 120) sowie die mittlere ringförmige magnetisierte Struktur Kränze bilden, die jeweils in Bestandselemente in Form identischer regelmäßig verteilter Sektoren geteilt sind, wobei die einzelnen Bestandselemente (151) des mindestens eines magnetisierten Kranzes (150), der eine Magnetisierungsverteilung aufweist, deren Ausrichtung wie in den Halbachsen Dipolen variiert, mindestens teilweise mit den einzelnen Bestandselementen (111, 121) des ersten und des zweiten magnetisierten Kranzes (110, 120) verschachtelt sind.

9.  Magnetisierte Struktur nach Anspruch 8, **dadurch gekennzeichnet, dass** die mittlere ringförmige Struktur, die zwischen dem ersten und dem zweiten magnetisierten Kranz (110, 120) liegt, außerdem mindestens zwei magnetisierte Kränze (130A, 130B) umfasst, die in Bezug zu der Ebene (P), die zu der Längsachse (z) senkrecht ist, symmetrisch sind und eine Magnetisierung mit paralleler axialer Ausrichtung der Längsachse (z) in die positive Richtung zu der Längsachse aufweisen, dass die mittlere ringförmige Struktur, die zwischen dem ersten und dem zweiten magnetisierten Kranz (110, 120) liegt, außerdem mindestens zwei magnetisierte Kränze (140A, 140B) aufweist, die in Bezug zu der Ebene (P), die zu der Längsachse (z) senkrecht ist, symmetrisch sind und eine Magnetisierung mit antiparalleler axialer Ausrichtung zu der Längsachse (z) aufweisen, und dass die einzelnen Bestandselemente, die die magnetisierten Kränze (130A, 130B, 140A, 140B) bilden, die zu der Ebene (P), die zu der Längsachse (z) senkrecht ist, symmetrisch sind und eine Magnetisierung mit paralleler axialer oder antiparalleler axialer Ausrichtung zu der Längsachse (z) aufweisen, mit den einzelnen Bestandselementen (151) des magnetisierten Kranzes (150), der eine Magnetisierungsverteilung aufweist, deren Ausrichtung wie in den Halbach-Dipolen variiert, verschachtelt sind.

**10.** Magnetisierte Struktur nach Anspruch 8, **dadurch gekennzeichnet, dass** der erste und der zweite magnetisierte Kranz (110, 120), die Kränze bilden, die jeweils einzelne Bestandselemente in Form identischer regelmäßig verteilter Sektoren bilden, in Abschnitte entlang der Längsachse (z) geteilt sind, wobei mindestens ein Abschnitt (110 A, 120 A), der möglichst nahe der Symmetrieebene (P), die zu der Längsachse (z) senkrecht ist, liegt, eine geringere Stärke aufweist als die anderen Abschnitte.

**11.** Magnetisierte Struktur nach einem der Ansprüche 8 bis 10, **dadurch gekennzeichnet, dass** die einzelnen Bestandselemente (111, 121) des ersten und zweiten magnetisierten Kranzes (110, 120) in die Azimutrichtung abwechselnd mit den einzelnen Bestandselementen (151) des magnetisierten Kranzes (150), der eine Magnetisierungsverteilung aufweist, deren Ausrichtung wie in den Halbach-Dipolen variiert, abwechselnd verschachtelt sind.

**Claims**

**1.** A magnetized structure that induces an homogeneous magnetic field for a nuclear magnetic resonance device comprising an assembly of magnetized parts comprising at least first and second magnetized rings (10, 20) disposed symmetrically relative to a plane (P) that is perpendicular to a longitudinal axis (z) and that contains a central area of interest, and at least one median annular magnetized structure disposed at least partly between the first and second magnetized rings (10, 20) and also disposed symmetrically relative to said plane (P), the first magnetized ring (10) being magnetized radially relative to the longitudinal axis (z) with divergent magnetization, the second magnetized ring (20) being magnetized radially relative to the longitudinal axis (z) with convergent magnetization, and the median annular magnetized structure being magnetized with an orientation different from that of the magnetization of the first and second magnetized rings (10, 20), **characterized in that** the median annular magnetized structure comprises at least one magnetized ring (50) having a magnetization distribution of orientation that varies as in Halbach dipoles, and **in that** the first and second magnetized rings (10, 20) and the median annular magnetized structure are each divided into individual components in the form of regularly distributed identical sectors (71, 81), **in that** the individual components of the pure rings of the first and second magnetized rings (10, 20) and of the median annular magnetized structure, except said at least one magnetized ring (50) having a magnetization distribution of orientation that varies as in Halbach dipoles, have a same magnetization distribution, **in that** the first and second magnetized rings (10, 20) and the median annular magnetized structure are contiguous along the longitudinal axis (z).

**2.** A magnetized structure according to claim 1 **characterized in that** there are at least twelve individual components in the form of regularly distributed identical sectors (71, 81) constituting a ring for each of the first and second magnetized rings (10, 20) and for the median annular magnetized structure in each ring.

**3.** A magnetized structure according to any one of claims 1 and 2, **characterized in that** the median annular structure between the first and second magnetized rings (10, 20) further comprises at least two magnetized rings (30A, 30B) symmetrical relative to said plane (P) perpendicular to the longitudinal axis (z) and having magnetization with an axial orientation parallel to said longitudinal axis (z) in the positive direction of said longitudinal axis.

**4.** A magnetized structure according to any one of claims 1 to 3, **characterized in that** the median annular structure lying between the first and second magnetized rings (10, 20) further comprises at least two magnetized rings (40A, 40B) symmetrical relative to said plane (P) perpendicular to the longitudinal axis (z) and having magnetization with an axial orientation antiparallel to said longitudinal axis (z).

**5.** A magnetized structure according to any one of claims 1 to 4, **characterized in that** all the individual components constituting a ring have a section consisting of a cylindrical ring sector.

6. A magnetized structure according to any one of claims 1 to 4, **characterized in that** all the individual components constituting a ring have a section of trapezoidal shape (71).

7. A magnetized structure according to any one of claims 1 to 4, **characterized in that** all the individual components constituting a ring have a section of disk shape (81).

8. A magnetized structure that induces an homogeneous magnetic field for a nuclear magnetic resonance device comprising an assembly of magnetized parts comprising at least first and second magnetized rings (110, 120) disposed symmetrically relative to a plane (P) that is perpendicular to a longitudinal axis (z) and that contains a central area of interest, and at least one median annular magnetized structure disposed at least partly between the first and second magnetized rings (110, 120) and also disposed symmetrically relative to said plane (P), the first magnetized ring (110) being magnetized radially relative to the longitudinal axis (z) with divergent magnetization, the second magnetized ring (120) being magnetized radially relative to the longitudinal axis (z) with convergent magnetization, and the median annular magnetized structure being magnetized with an orientation different from that of the magnetization of the first and second magnetized rings (110, 120), **characterized in that** the median annular magnetized structure comprises at least a magnetized ring (150) having a magnetization distribution of orientation that varies as in Halbach dipoles, the first and second magnetized rings (110, 120) and the median annular magnetized structure constitute rings, each divided into individual components in the form of regularly distributed identical sectors, the individual components (151) of said at least one the magnetized ring (150) having a magnetization distribution of orientation that varies as in Halbach dipoles being at least in part interleaved with the individual components (111, 121) of the first and second magnetized rings (110, 120).

9. A magnetized structure according to claim 8, **characterized in that** the median annular structure comprised between the first and second magnetized ring (110, 120) further comprises at least two magnetized rings (130A, 130B) symmetrical relative to the plane (P) perpendicular to said longitudinal axis (z) and having magnetization with an axial orientation parallel to said longitudinal axis (z) in the positive direction of said longitudinal axis, **in that** the median annular structure comprised between the first an second magnetized rings (110, 120) further comprises at least two magnetized rings (140A, 140B) symmetrical relative to said plane (P) perpendicular to said longitudinal axis (z) and having magnetization with an axial orientation antiparallel to said longitudinal axis (z) and **in that** the individual components forming magnetized rings (130A, 130B, 140A, 140B) symmetrical relative to said plane (P) perpendicular to the longitudinal axis (z) and having magnetization with axial orientation parallel or antiparallel to said longitudinal axis (z) are interleaved with the individual components (151) of the magnetized ring (150) having a magnetization distribution of orientation that varies as in Halbach dipoles.

10. A magnetized structure according to claim 8, **characterized in that** the first and second magnetized rings (110, 120) constituting rings, each divided into individual components in the form of regularly distributed identical sectors are divided into slices along the longitudinal axis (z), at least one of the slices (110A, 120A) situated the closest to said plane (P) of symmetry perpendicular to said longitudinal axis (z) being thinner than the other slices.

11. A magnetized structure according to any one of claims 8 to 10, **characterized in that** the individual components (111, 121) of the first and second magnetized rings (110, 120) are interleaved in the azimuth direction alternately with the individual components (151) of the magnetized ring (150) having a magnetization distribution of orientation that varies as in Halbach dipoles.

FIG.1

FIG.2

FIG.3

10

110

FIG.8A

FIG.4

20

120

FIG.9A

FIG.5

30

130

FIG.10A

FIG.6

40

140

FIG.11A

150

FIG.12A

FIG.7

50

110'

FIG.8B

110"

FIG.8C

120'

FIG.9B

120"

FIG.9C

130'

FIG.10B

130"

FIG.10C

140'

FIG.11B

140"

FIG.11C

150'

FIG.12B

150"

FIG.12C

FIG.13

FIG.14

FIG.15

FIG.16

50B

FIG.16A

151  111  111  151  151  151  151  111  151  111

FIG.17

50A

FIG.17A

151  121  121  151  151  151  121  121  151

FIG.18

71  50  0 Y  -50  100  Z  50  50  0  X  -50  70

FIG.19

81  50  Y 0  -50  50  Z 0  -50  -50  X 0  50  80

FIG.20

FIG.21

FIG.22

FIG.23

FIG.24

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5014032 A
- US 2960649 A
- WO 2006024775 A
- WO 2007120057 A
- US 5148138 A
- WO 8810500 A
- US 4999600 A
- US 5332971 A
- US 5523732 A
- WO 2006047580 A2

**Littérature non-brevet citée dans la description**

- **K. HALBACH.** Design of permanent multipole magnets with oriented rare earth cobalt material. *Nuclear Instruments and Methods,* 1980, vol. 169, 1-10
- **R.D. SCHLUETER ; T.F. BUDINGER.** Magic angle rotating field NMR/MRI magnet for in vivo monitoring of tissue. *IEEE Transactions on Applied Superconductivity,* Juin 2008, vol. 18 (2), 864-867
- **R.A. WIND ; J.Z. HU ; D.N. ROMMEREIM.** High résolution H NMR spectroscopy in organs and tissues using slow magic angle spinning. *Magnetic Resonance in Medicine,* 2001, vol. 46, 213-218